# EUROPEAN PATENT SPECIFICATION

(11) **EP 4 292 853 B1**
(45) Date of publication and mention of the grant of the patent: **27.05.2026**
(21) Application number: 23178794.6
(22) Date of filing: 12.06.2023
(51) Int. Cl.: B60K 11/02, B60H 1/00, F01P 7/16, F04D 15/00, F04D 29/42, F04D 29/58, B60H 1/14, B60H 1/22, F01P 5/12, F04D 13/14

(54) **SWITCH PUMP FLOW SCHEME**
SCHALTBARES PUMPENFLUSSSCHEMA
SCHÉMA D'ÉCOULEMENT DE POMPES COMMUTABLE

(30) Priority: 13.06.2022 US 202263351743 P
(43) Date of publication of application: 20.12.2023
(73) Proprietor: Cooper-Standard Automotive Inc., Northville, MI 48168 (US)
(72) Inventor: MALONE, David S., Northville, 48168 (US)
(74) Representative: Kilburn & Strode LLP

(56) References cited:
- EP-A1- 3 121 040
- DE-A1- 102018 220 150
- DE-A1- 102020 206 268
- US-A1- 2019 047 352

## Description

### FIELD

The field is generally related to a pump for switching flow to heat generating or absorbing components.

### BACKGROUND

Pumps are known and commonly used to move fluids, such as coolant in a vehicle. One example is cooling systems with water pumps, which are used for the cooling of different electrical or mechanical components of a vehicle. In hybrid or purely electric vehicles, electrical components need to be cooled. Valves are used to ensure the distribution of the coolant throughout the cooling system. The valves each require an actuator with electrical control and a holder on a component of the vehicle, which results in high component costs.

In some vehicles, more than one cooling loop may be employed to cool heat generating components and to modulate the temperature of the driver cabin. Each loop requires a pump and a valve to direct flow through the appropriate loop.

It is an object of the present disclosure to employ a pump with an integrated valve that can control the flow from the pump through a plurality of outlets using a minimal set of components.
EP3121040A1 to Aleees Eco Ark (Cayman) Co., Ltd. discloses a thermal control system for an electric vehicle, comprising a composite cooling architecture, the thermal control system being automatically controlled in one of three operation modes.

### SUMMARY

This disclosure relates to a process for cooling a heat generating component of a vehicle comprising pumping coolant from a first pump while a first pump is in a chiller mode in a first loop comprising a component heat exchanger and a chiller module. Coolant is pumped from the first pump while the first pump is in a recirculation mode in a second loop comprising a heater module, and a cabin heat exchanger or back to said component heat exchanger in said first loop, wherein said first pump has a first outlet which directs coolant to said chiller module in said first loop and said first pump has a second outlet which directs coolant to said second loop or back to said component heat exchanger in said first loop. A second pump pumps coolant in the second loop while the second pump is in an isolated mode and from the second loop into the first loop while the second pump is in a linked mode.

The disclosure also relates to an apparatus for cooling a heat generating component of a vehicle comprising a first loop comprising a component heat exchanger and a chiller module and a second loop comprising a heater module and a cabin heat exchanger. A first pump is switchable between a chiller mode and a recirculation mode. The first loop is in downstream communication with the first pump while in the chiller mode, and the second loop or the component heat exchanger is in downstream communication with the first pump while in the recirculation mode, wherein said first pump has a first outlet which directs coolant to said first loop and said first pump has a second outlet which directs coolant to said second loop or the component heat exchanger.

In an embodiment, a second pump is switchable between an isolated mode and a linked mode. The second loop is in downstream communication with the second pump while in the isolated mode, and the first loop is in downstream communication with the second pump while is in the linked mode.

Other technical features may be readily apparent to one skilled in the art from the following figures, descriptions, and claims.

### BRIEF DESCRIPTION OF THE DRAWINGS

For a more complete understanding of this disclosure, reference is now made to the following description, taken in conjunction with the accompanying drawings, in which:
FIG.1 illustrates a schematic view of a system of the present disclosure;
FIG. 2 illustrates a schematic view of a system of the present disclosure;
FIG. 3 illustrates a schematic view of a system of the present disclosure;
FIG. 4 illustrates a schematic view of a system of the present disclosure;
FIG. 5 illustrates a perspective view of a pump of the present disclosure; and
FIG. 6 illustrates a sectional view through the valve member of the pump of FIG. 5 taken at segment 6-6.

### DEFINITIONS

The term "communication" means that fluid flow is operatively permitted between enumerated components, which may be characterized as "fluid communication". The term "communication" may also mean that data or signals are transmitted between enumerated components which may be characterized as "informational communication".

The term "downstream communication" means that at least a portion of fluid flowing to the subject in downstream communication may operatively flow from the object with which it fluidly communicates.

The term "upstream communication" means that at least a portion of the fluid flowing from the subject in upstream communication may operatively flow to the object with which it fluidly communicates.

The term "direct communication" means that fluid flow from the upstream component enters the downstream component without passing through any other intervening vessel.

The term "indirect communication" means that fluid flow from the upstream component enters the downstream component after passing through an intervening vessel.

The term "bypass" means that the object is out of downstream communication with a bypassing subject at least to the extent of bypassing.

### DETAILED DESCRIPTION

The Figures, discussed below, and the various embodiments used to describe the principles of the present disclosure in this patent document are by way of illustration only and should not be construed in any way to limit the scope of the invention. Those skilled in the art will understand that the principles of the disclosure may be implemented in any type of suitably arranged device or system.

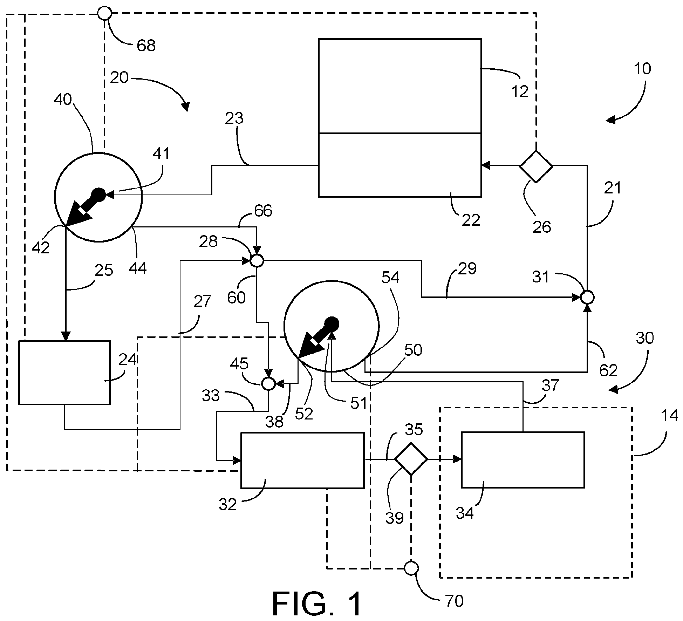

FIG. 1 depicts a system 10 for regulating the temperature of a heat generating component 12 of a vehicle. The heat generating component 12 may be a battery for powering a hybrid or an electrical vehicle. The system 10 can also be employed to modulate temperature in a driver cabin 14. The system 10 may include a first loop 20 and a second loop 30. The system 10 includes a first pump 40 and a second pump 50. The pumps 40, 50 pump coolant through the loops 20, 30, respectively.

A first loop 20 comprises a component heat exchanger 22 and a chiller module 24. The first loop 20 comprises fluid lines 21, 23 29 and either lines 25 and 27 or line 66. In FIG. 1, the first loop 20 includes lines 25 and 27 instead of line 66. A first fluid line 21 transports coolant to the component heat exchanger 22 to exchange heat with the component thereby heating or cooling the coolant and cooling or heating the heat generating component 12, respectively. A first sensor 26 is in communication with the first line 21.

A second fluid line 23 transports coolant to an inlet 41 of a first pump 40. The inlet 41 to the first pump 40 receives coolant directly from the component heat exchanger 22 because the first pump is in direct downstream communication with the component heat exchanger 22.

The first pump 40 has two outlets and is switchable between two modes, a chiller mode and a recirculation mode. The first loop 20 is in downstream communication with the first pump 40 while in the chiller mode. When the first pump is in the chiller mode a valve in the first pump 40 opens the first outlet 42 to discharge coolant from the first outlet while the second outlet may be closed 44. The first outlet 42 directs coolant to the first loop 20 through a third line 25 to the chiller module 24. The chiller module 24 may be on or off. When on, the chiller 24 cools the coolant received from the first pump 40 in the third line 25. When off, the chiller module 24 allows the coolant to pass through without cooling. The chiller module 24 may cool the coolant by means of Peltier electric device. A Peltier electric device applies a current through a junction connecting two metals to absorb heat at the junction to balance the difference in the chemical potential of the two metals to produce a cooling effect.

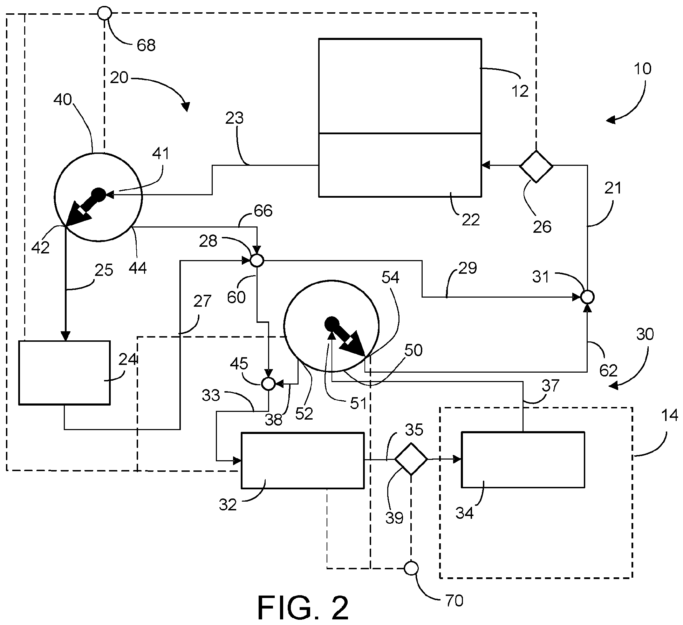

A second loop 30 comprises a heater module 32 and a cabin heat exchanger 34. The second loop 30 comprises lines 33, 35, 37 and sometimes line 52. In FIG. 2, the second loop 30 includes line 52. A sixth fluid line 33 transports coolant to the heater module 32. When the heater module 32 is on, it heats coolant passing through the heater module. If the heater module is off, the coolant passes through without heating. The heater module 32 may heat coolant by use of a Seebeck electrical device which operates on the reverse principle as the Peltier electrical device previously described for the chiller module 24. Coolant exits the heater module 32 in a seventh line 35 and passes to the cabin heat exchanger 34.

In the cabin heat exchanger 34 air from the cabin 14 is indirectly heat exchanged with coolant from the seventh line 35. If the heater module 32 is on, the coolant will heat the cabin air. If heater module 32 is off, the first pump 40 is in the chiller mode and the chiller module 24 is on, the coolant will cool the cabin air. Coolant will exit the cabin heat exchanger 34 in eighth fluid line 37 and flow to an inlet 51 of the second pump 50. The inlet 51 to the second pump 50 receives coolant directly from the cabin heat exchanger 34 because the second pump is in direct downstream communication with the cabin heat exchanger.

The second pump 50 has two outlets. The second pump 50 is switchable between an isolated mode and a linked mode. The second loop is in downstream communication with the second pump while in the isolated mode. When the second pump 50 is in the isolated mode a valve in the second pump 50 opens a first outlet 52 to discharge coolant from the first outlet 52 while a second outlet 54 may be closed. The first outlet 52 directs coolant through a ninth line 38 to a third junction 45 from which it flows with any coolant from a first tie line 60 in the second loop 30 through the sixth fluid line 33 back to the heater module 32. In the isolated mode, the second pump 50 only pumps coolant through the second loop 30 via the first outlet 52. Furthermore, in the isolated mode, coolant from the heater module only heats the cabin air through the cabin heat exchanger 34. A second sensor 39 is in communication with the seventh line 35.

When the first pump 40 is in chiller mode and the second pump is in isolated mode, the cooled or uncooled coolant from the chiller module 24 may be transported in a fourth fluid line 27 through a first junction 28 with a first bypass line 66 in the first loop 20 to a fifth line 29 and through a second junction 31 with a second bypass line 62 in the second loop and back through the first line 21 to the component heat exchanger 22 to perhaps cool the heat generating component 12.

When the second pump 50 is in the isolated mode, the first loop 20 and the second loop 30 circulate independently. However, the first loop 20 and the second loop 30 communicate minorly by fluid expansion and contraction through the first tie line 60 which keeps the loops in equilibrium.

The first sensor 26 senses the temperature of coolant in line 21 entering the component heat exchanger 22. The sensor 26 sends a signal to a controller 68 for signaling the first pump 40 to operate in the chiller mode and to turn the chiller module 24 on if the temperature of the coolant entering the component heat exchanger is higher than a set point as shown in FIG. 1. The first sensor 26 may send a signal directly to the first pump 40 or the chiller module 24.

The second sensor 39 senses the temperature of the coolant in line 35 entering the cabin heat exchanger 34. The second sensor 39 sends a signal to a second controller 70 for signaling the second pump 50 to operate in isolation mode and to turn the heating module 32 on if the temperature of the coolant entering the cabin heat exchanger 34 in line 35 is below a set point as shown in FIG. 1. The set point of the sensor 39 in line 35 may be adjusted based on the interior setting in the vehicle cabin 14. It is envisioned that the first controller 68 and the second controller 70 may also be combined into a single controller.

FIG. 2 shows the system 10 with the first pump 40 still in chiller mode and the second pump 50 in linked mode. In linked mode, the first loop 20 is in downstream communication with the second pump 50. In linked mode, the coolant in the first loop 20 and the second loop 30 circulate dependently. In FIG. 2, the first loop 20 comprises fluid lines 21, 23, 25, 27 and 29; and the second loop 30 comprises lines 33, 35 and 37. The coolant from the chiller module 24 in line 27 is pumped through the first junction 28 and through the first tie line 60 and the second junction 45 into the second loop 30. In the second loop 30, the coolant is pumped through the line 33 into the heater module 32 to be heated if the heater module is on then through the line 35 and into the cabin heat exchanger 34 to modulate heat in the cabin 14. Coolant from the cabin heat exchanger 34 flows to the inlet 51 of the second pump 50.

In linked mode, the valve on the second pump opens to the second outlet 54 which directs coolant to the first loop 30 through a second bypass line 62. The valve may close the first outlet 52. The second pump in linked mode pumps coolant from the second outlet 54 through the second bypass line 62 to a second junction 31 and along with minor coolant from the fifth line 29 flows in the first line 21 to the component heat exchanger 22 in the first loop 20. In linked mode, the second pump 50 pumps coolant from the second pump from the second loop 30 into the first loop 20. In linked mode, minor coolant from the first loop 20 and coolant from the second loop 30 meet at the second junction 31 and flow together to the component heat exchanger 22 in line 21.

The first sensor 26 senses the temperature of coolant in line 21 entering the component heat exchanger 22. If the temperature of the coolant entering the component heat exchanger 22 is higher than a set point, the first sensor 26 sends a signal to a controller 68 signaling the first pump 40 to operate in the chiller mode and to turn the chiller module 24 on as shown in FIG. 2. The first sensor 26 may send a signal directly to the first pump 40 or the chiller module 24.

The second sensor 39 senses the temperature of the coolant in line 35 entering the cabin heat exchanger 34. The second sensor 39 sends a signal to a second controller 70 for signaling the second pump 50 to operate in linked mode and to turn the heating module 32 off if the temperature of the coolant entering the cabin heat exchanger 34 in line 35 is higher than a set point as shown in FIG. 2. The second sensor 39 may send a signal directly to the second pump 50 or the heater module 32.

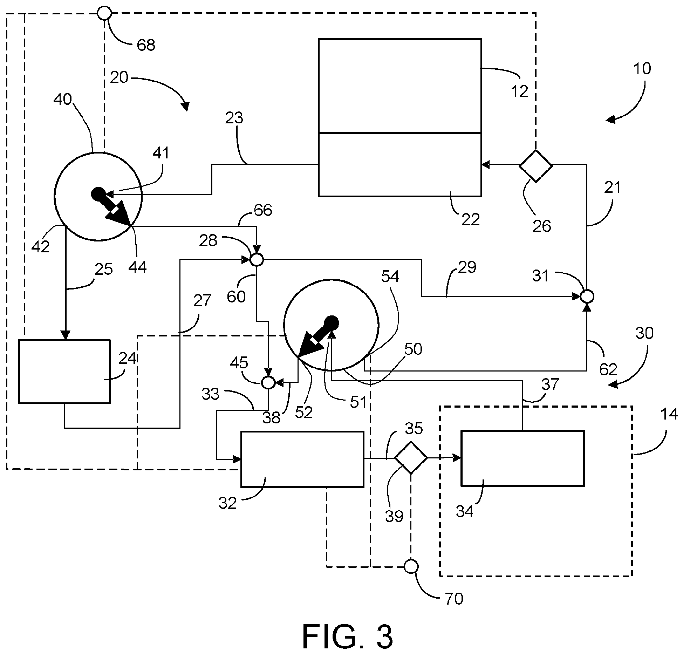

FIG. 3 depicts the system 10 with the first pump 40 in recirculation mode and the second pump 50 in isolation mode. The second loop 30 is in downstream communication with the second pump 50 while in the recirculation mode. In FIG. 3, the first loop 20 comprises fluid lines 21, 23, 66 and 29; and the second loop 30 comprises fluid lines 33, 35, 37 and 52. In recirculation mode, a valve of the first pump 40 opens a second outlet 44 to recirculate coolant in the first loop 20 back to the component heat exchanger 22. The valve of the first pump 40 may close the first outlet 42. The first pump 40 pumps coolant through the second outlet 44 to the first bypass line 66 through the first junction 28 and by the way of least resistance through the fifth line 29 through the third junction 31 through the first line 21 and back to the component heat exchanger 22 to maintain the temperature of the component heat exchanger. In recirculation mode, the first pump just recirculates coolant in the first loop 20 to the component heat exchanger 22 bypassing the chiller module 24.

The second pump 50 in isolated mode has an open first outlet 52 to discharge coolant from the first outlet. The first outlet 52 directs coolant to the second loop 30 through a ninth line 38 to a third junction 45 from which coolant flows with any coolant from a first tie line 60 through the sixth fluid line 33 back to the heater module 32. In isolation mode, the second pump 50 only pumps coolant through the second loop 30 via the first outlet 52. Furthermore, in the isolation mode, coolant from the heater module 32 only heats the cabin air through the cabin heat exchanger 34.

When the second pump 50 is in isolation mode coolant is circulated through the first loop 20 and the second loop 30 independently. However, the first loop 20 and the second loop 30 communicate minorly by fluid expansion and contraction through the first tie line 60 which keeps the loops in equilibrium.

The first sensor 26 senses the temperature of coolant in line 21 entering the component heat exchanger 22. If the temperature of the coolant entering the component heat exchanger 22 is lower than a set point, the first sensor 26 sends a signal to a controller 68 for signaling the first pump 40 to operate in the recirculation mode and to turn the chiller module 24 off as shown in FIG. 3. The first sensor 26 may send a signal directly to the first pump 40 or the chiller module 24.

The second sensor 39 senses the temperature of the coolant in line 35 entering the cabin heat exchanger 34. The second sensor 39 sends a signal to a second controller 70 signaling the second pump 50 to operate in isolation mode and to turn the heating module 32 on if the temperature of the coolant entering the cabin heat exchanger 34 in line 39 is below a set point as shown in FIG. 3.

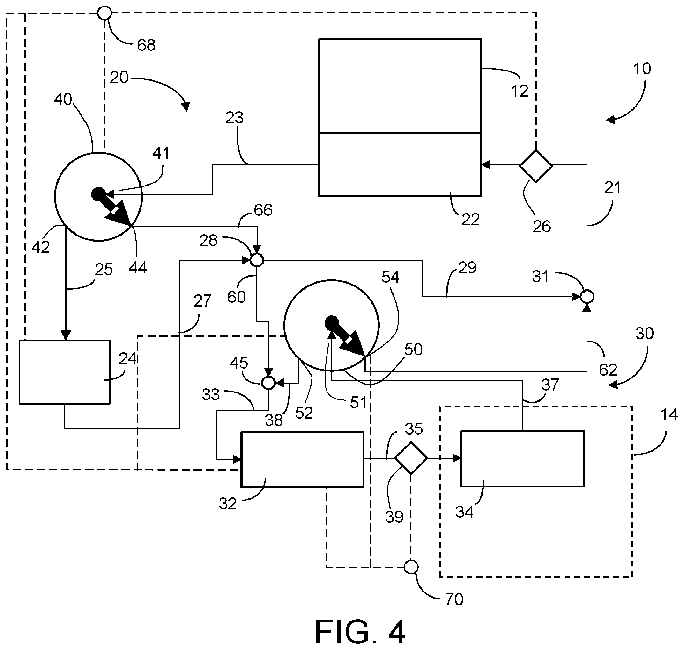

FIG. 4 depicts the system 10 with the first pump 40 in recirculation mode and the second pump 50 in linked mode. In FIG. 4, the first loop 20 comprises fluid lines 21, 23, 66 and 29; and the second loop 30 comprises lines 33, 35 and 37. In recirculation mode, as in FIG. 3, the valve of the first pump 40 opens a second outlet 44 to direct coolant to the second loop 30 and may close the first outlet 42. The first pump 40 pumps coolant through the second outlet 44 in the first bypass line 66 through the first junction 28 and by the way of least resistance through the first tie line 60 through the second junction 45 along with coolant pumped from the second pump 50 in line 38 and is fed in line 33 to the heater module 32, through line 35 and then to the cabin heat exchanger 34. The coolant exits the cabin heat exchanger 34 in line 37 and is fed to the inlet 51 of the second pump 50. Coolant in the first bypass line 66 only minorly travels through the fifth line 29 in the first loop 20. In recirculation mode, the first pump just recirculates coolant in the first loop 20 bypassing the chiller module 24.

In linked mode, the valve on the second pump 50 opens to the second outlet 54 which directs coolant through a second bypass line 62. In linked mode, the valve on the second pump 50 may close the first outlet 52. The coolant in the first loop 20 and the second loop 30 circulate dependently. The coolant from the first bypass line 66 is pumped through the first junction 28 and through the first tie line 60 and the second junction 45 into the second loop 30. In the second loop 30, the coolant is pumped through the line 33 into the heater module 32 to be heated if the heater module is on then through the line 35 and into the cabin heat exchanger 34 to modulate heat in the cabin 14. Coolant from the cabin heat exchanger 34 flows to the inlet 51 of the second pump 50. The second pump is in linked mode, so the valve of the second pump 50 is open to the second outlet 54 and may close the first outlet 52. In this mode, the second pump directs coolant from the second outlet 54 through the second bypass line 62. The second bypass line 62 feeds a second junction 31 and along with coolant from the fifth line 29 flows in first line 21 to the component heat exchanger 22 in the first loop 20. In linked mode, coolant from the first loop 20 only minorly joins coolant from the second loop 30 at the second junction 31 from line 29 and flow together to the component heat exchanger 22 in line 21.

The first sensor 26 senses the temperature of coolant in line 21 entering the component heat exchanger 22. The sensor 26 sends a signal to a controller 68 for signaling the first pump 40 to operate in the recirculation mode and to turn the chiller module 24 off if the temperature of the coolant entering the component heat exchanger is lower than a set point as shown in FIG. 4. The first sensor 26 may send a signal directly to the first pump 40 or the chiller module 24.

The second sensor 39 senses the temperature of the coolant in line 35 entering the cabin heat exchanger 34. The second sensor 39 sends a signal to a second controller 70 for signaling the second pump 50 to operate in linked mode and to turn the heating module 32 on if the temperature of the coolant entering the cabin heat exchanger 34 in line 39 is below a set point as shown in FIG. 4. The second sensor 39 may send a signal directly to the second pump 50 or the heater module 32.

If the temperature of the coolant entering the component heat exchanger 22 read by the first sensor 26 is at the set point, the first sensor 26 sends a signal to the first controller 68 which sends no signal to the first pump 40 other than to operate in the mode it was previously in and to turn off the chiller module 24.

If the temperature of the coolant entering the cabin heat exchanger 34 read by the second sensor 39 is at the set point, the second sensor 26 sends no signal to the second controller 70 other than to operate in the mode it was previously in and to turn off the heater module 32.

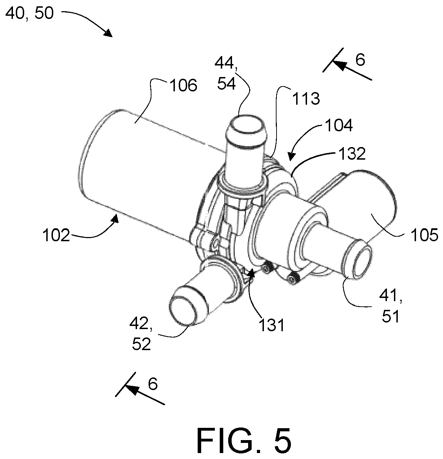

FIG. 5 illustrates an example of a first pump 40 and a second pump 50 for pumping the coolant in a vehicle. As can be appreciated, the pump 40, 50 may also be used in non-vehicle applications. The pump 40, 50 is an integration of a pump and a valve for selectively controlling flow from the pump. The pump 40, 50 includes a pump motor section 102 and a pump section 104. The pump motor section 102 includes a motor housing 106.

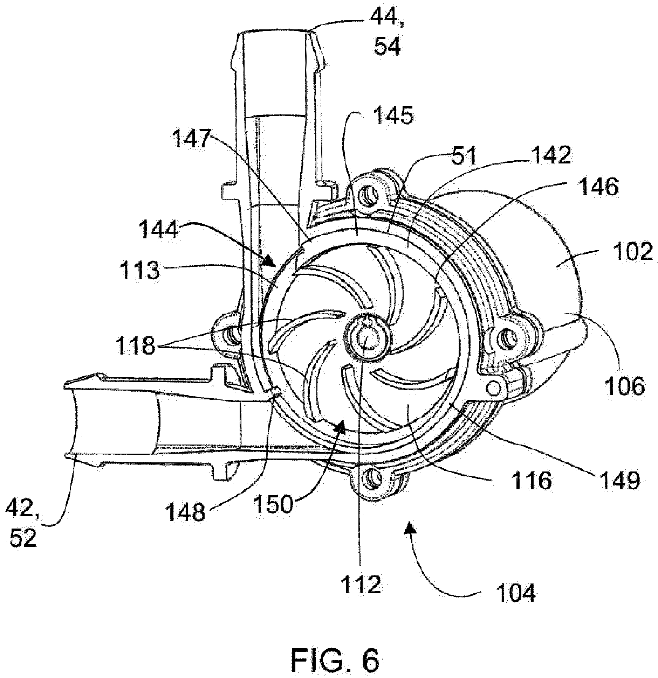

FIG. 6 depicts a cross-sectional perspective view of the pump section 104 taken at segment 6-6 of FIG. 5. The pump motor housing 106 contains a pump motor (not shown) and a motor shaft 112 is installed through an opening of a pump motor mounting plate 113. The pump motor drives an impeller 116 to move the fluid. An impeller 116 includes a plurality of impeller vanes 118 for moving a coolant from the inlet to the outlet. The impeller 116 is configured to be rotatable within the pump section 104 driven by the motor shaft 112. The pump motor includes electrical connections (not shown) that are adapted to receive electrical power from a remotely located power source to energize and operate the pump motor.

In FIG. 5, the pump housing 131 of pump section 104 is formed essentially cylindrically and comprises a peripheral exterior wall 132. A fluid inlet 41, 51, for example a suction inlet for sucking in a fluid, in this example a coolant, is positioned centrally to the rotary axis of the pump housing 131. The pump housing 131 also includes at least two fluid outlets for discharging fluid from the pump section 104. In this embodiment, a first outlet 42, 52 and a second outlet, 44, 54 are shown. A first outlet 42, 52 and a second fluid outlet 44, 54 extend from the wall 132 and are axially offset from each other such that the centers of the fluid outlets 42, 44 and 52, 54 in the example, are oriented 90 degrees from the other. It will be appreciated by those skilled in the art, that fluid outlets 42, 44 and 52, 54 may be offset from each other at any other convenient angle. A valve actuator may be housed in an actuator housing 105.

Referring to FIG. 6, the fluid outlets 42, 44 and 52, 54 are in downstream communication with a pump cavity 150. An adjustable valve member 142 is radially located outside the impeller 116 and inside the pump cavity 150. The valve member 142 is arranged to adjustably direct the fluid through the respective fluid outlets 42, 44 and 52, 54. The valve member 142 has an annular wall 145 with an exterior wall surface 149 and an interior wall surface 146 and an opening 144 extending through wall 145. In this example, wall 145 of the valve member 142 is spirally voluted from a generally thicker wall section at a first end 147 of opening 144 to a generally thinner wall section at a second end 148 of the opening 144. The impeller 116 is arranged to rotate inside the annular wall 145 and particularly the voluted interior wall surface 146.

In operation, rotation of the valve member 142 selectively positions opening 144 to divert fluid flow from the inlet 41, 51 to the pump cavity 150 to the first fluid outlet 42, 52 or the second fluid outlets 44, 54 thereby controlling the discharge of fluid from the pump section 104.

The disclosure sets for a process and apparatus that can control temperature of a heat generating component and a vehicle cabin by means of only two pumps without requiring separate valves and the additional fluid lines and controls appurtenant thereto.

It may be advantageous to set forth definitions of certain words and phrases used throughout this patent document. The term "communicate," as well as derivatives thereof, encompasses both direct and indirect communication. The terms "include" and "comprise," as well as derivatives thereof, mean inclusion without limitation. The term "or" is inclusive, meaning and/or. The phrase "associated with," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, have a relationship to or with, or the like. The phrase "at least one of," when used with a list of items, means that different combinations of one or more of the listed items may be used, and only one item in the list may be needed. For example, "at least one of: A, B, and C" includes any of the following combinations: A, B, C, A and B, A and C, B and C, and A and B and C.

The description in the present application should not be read as implying that any particular element, step, or function is an essential or critical element that must be included in the claim scope. The scope of patented subject matter is defined only by the allowed claims.

While this disclosure has described certain embodiments and generally associated methods, alterations and permutations of these embodiments and methods will be apparent to those skilled in the art, within the scope of the invention as defined by the claims. Accordingly, the above description of example embodiments does not define or constrain this disclosure. Other changes, substitutions, and alterations are also possible without departing from the scope of this invention, as defined by the following claims.

## Claims

1. A process for cooling a heat generating component (12) of a vehicle comprising:
pumping coolant from a first pump (40) while a first pump is in a chiller mode in a first loop (20) comprising a component heat exchanger (22) and a chiller module (24); and
pumping coolant from said first pump (40) while the first pump is in a recirculation mode in a second loop (30) comprising a heater module (32) and a cabin heat exchanger (34) or back to said component heat exchanger (22) in said first loop (20), **characterized in that**
said first pump (40) has a first outlet (42) which directs coolant to said chiller module (24) in said first loop a (20) and said first pump 1 (40) has a second outlet (44) which directs coolant to said second loop (30) or back to said component heat exchanger (22) in said first loop (20).

2. The process of claim 1 further comprising pumping coolant from said second pump (50) in said second loop (30) while the second pump (50) is in an isolated mode; and
pumping coolant from said second pump (50) from said second loop (30) into said first loop (20) while the second pump is in a linked mode.

3. The process of claim 2 wherein said second pump (50) has a first outlet (52) which directs coolant to said second loop (30) and said second pump (50) has a second outlet (54) which directs coolant to said first loop (20).

4. The process of any preceding claim wherein an inlet to the first pump (40) receives coolant directly from the component heat exchanger (22).

5. The process of claim 2 wherein an inlet to the second pump (50) receives coolant directly from the cabin heat exchanger (34).

6. The process of any preceding claim further comprising sensing (26) the temperature of the coolant entering the component heat exchanger (22) to determine to operate the first pump (40) in chiller mode if the temperature of the coolant entering the component heat exchanger (22) is higher than a set point and to operate the first pump (40) in recirculation mode if the temperature of the coolant entering the component heat exchanger (22) is lower than a set point.

7. The process of claim 2 further comprising sensing (39) the temperature of the coolant entering the cabin heat exchanger (34) to determine to operate the second pump (50) in linked mode if the temperature of the coolant entering the cabin heat exchanger (34) is above a set point and to operate the second pump (50) in isolated mode if the temperature of the coolant entering the cabin heat exchanger (34) is below a set point.

8. An apparatus for cooling a heat generating component (12) of a vehicle comprising
a first loop (20) comprising a component heat exchanger (22) and a chiller module (24),
a second loop (30) comprising a heater module (32) and a cabin heat exchanger (34);
a first pump (40) switchable between a chiller mode and a recirculation mode, the first loop (20) being in downstream communication with said first pump (40) while in said chiller mode and the second loop (30) or the component heat exchanger (22) being in downstream communication with said first pump (40) while in said recirculation mode,
**characterized in that** said first pump (40) has a first outlet (42) which directs coolant to said first loop (20) and said first pump (40) has a second outlet (44) which directs coolant to said second loop (30) or the component heat exchanger (22).

9. The apparatus of claim 8 wherein said second pump (50) is switchable between an isolated mode and a linked mode, said second loop (30) is in downstream communication with said second pump (50) while in said isolated mode, and said first loop (20) is in downstream communication with said second pump (50) while in said linked mode.

10. The apparatus of claim 9 wherein said second pump (50) has a first outlet (52) which directs coolant to said second loop (30) and said second pump (50) has a second outlet (54) which directs coolant to said first loop (20).

11. The apparatus of any one of claims 8 to 10 wherein an inlet (41) (52) to the first pump (40) is in direct downstream communication with the component heat exchanger (22).

12. The apparatus of claim 9 wherein an inlet (51) to the second pump (50) is in direct downstream communication with the cabin heat exchanger (34).

13. The apparatus of any one of claims 8 to 12 further comprising a first sensor (26) for sensing the temperature of the coolant entering the component heat exchanger (22) and a controller (68) for signaling the first pump (40) to operate in the chiller mode if the temperature of the coolant entering the component heat exchanger (22) (52) is higher than a set point and to operate the first pump (40) in recirculation mode if the temperature of the coolant entering the component heat exchanger (22) is lower than a set point.

## Patentansprüche

1. Verfahren zum Kühlen einer wärmeerzeugenden Komponente (12) eines Fahrzeugs, umfassend:
Pumpen von Kühlmittel von einer ersten Pumpe (40), während sich eine erste Pumpe in einem Kühlermodus in einer ersten Schleife (20) befindet, die einen Komponentenwärmetauscher (22) und ein Kühlermodul (24) umfasst; und
Pumpen von Kühlmittel von der ersten Pumpe (40), während sich die erste Pumpe in einem Rezirkulationsmodus in einer zweiten Schleife (30) befindet, die ein Heizmodul (32) und einen Kabinenwärmetauscher (34) umfasst, oder zurück zu dem Komponentenwärmetauscher (22) in der ersten Schleife (20), **dadurch gekennzeichnet, dass** die erste Pumpe (40) einen ersten Auslass (42) aufweist, der Kühlmittel zu dem Kühlermodul (24) in der ersten Schleife (20) leitet, und die erste Pumpe (40) einen zweiten Auslass (44) aufweist, der Kühlmittel zu der zweiten Schleife (30) oder zurück zu dem Komponentenwärmetauscher (22) in der ersten Schleife (20) leitet.

2. Verfahren nach Anspruch 1, ferner umfassend Pumpen von Kühlmittel von der zweiten Pumpe (50) in der zweiten Schleife (30), während sich die zweite Pumpe (50) in einem isolierten Modus befindet; und
Pumpen von Kühlmittel von der zweiten Pumpe (50) aus der zweiten Schleife (30) in die erste Schleife (20), während sich die zweite Pumpe in einem verknüpften Modus befindet.

3. Verfahren nach Anspruch 2, wobei die zweite Pumpe (50) einen ersten Auslass (52) aufweist, der Kühlmittel zu der zweiten Schleife (30) leitet, und die zweite Pumpe (50) einen zweiten Auslass (54) aufweist, der Kühlmittel zu der ersten Schleife (20) leitet.

4. Verfahren nach einem der vorhergehenden Ansprüche, wobei ein Einlass zu der ersten Pumpe (40) Kühlmittel direkt von dem Komponentenwärmetauscher (22) empfängt.

5. Verfahren nach Anspruch 2, wobei ein Einlass zu der zweiten Pumpe (50) Kühlmittel direkt von dem Kabinenwärmetauscher (34) empfängt.

6. Verfahren nach einem der vorhergehenden Ansprüche, ferner umfassend Erfassen (26) der Temperatur des in den Komponentenwärmetauscher (22) eintretenden Kühlmittels, um zu bestimmen, dass die erste Pumpe (40) im Kühlermodus betrieben wird, wenn die Temperatur des in den Komponentenwärmetauscher (22) eintretenden Kühlmittels höher als ein Sollwert ist, und um die erste Pumpe (40) im Rezirkulationsmodus zu betreiben, wenn die Temperatur des in den Komponentenwärmetauscher (22) eintretenden Kühlmittels niedriger als ein Sollwert ist.

7. Verfahren nach Anspruch 2, ferner umfassend Erfassen (39) der Temperatur des in den Kabinenwärmetauscher (34) eintretenden Kühlmittels, um zu bestimmen, dass die zweite Pumpe (50) in einem verknüpften Modus betrieben wird, wenn die Temperatur des in den Kabinenwärmetauscher (34) eintretenden Kühlmittels über einem Sollwert liegt, und um die zweite Pumpe (50) in einem isolierten Modus zu betreiben, wenn die Temperatur des in den Kabinenwärmetauscher (34) eintretenden Kühlmittels unter einem Sollwert liegt.

8. Einrichtung zum Kühlen einer wärmeerzeugenden Komponente (12) eines Fahrzeugs, umfassend:
eine erste Schleife (20), die einen Komponentenwärmetauscher (22) und ein Kühlermodul (24) umfasst,
eine zweite Schleife (30), die ein Heizmodul (32) und einen Kabinenwärmetauscher (34) umfasst;
eine erste Pumpe (40), die zwischen einem Kühlermodus und einem Rezirkulationsmodus umschaltbar ist, wobei die erste Schleife (20) in stromabwärtiger Verbindung mit der ersten Pumpe (40) steht, während sie sich im Kühlermodus befindet, und die zweite Schleife (30) oder der Komponentenwärmetauscher (22) in stromabwärtiger Verbindung mit der ersten Pumpe (40) steht, während sie sich im Rezirkulationsmodus befindet,
**dadurch gekennzeichnet, dass** die erste Pumpe (40) einen ersten Auslass (42) aufweist, der Kühlmittel zu dem ersten Kreislauf (20) leitet, und die erste Pumpe (40) einen zweiten Auslass (44) aufweist, der Kühlmittel zu dem zweiten Kreislauf (30) oder dem Komponentenwärmetauscher (22) leitet.

9. Vorrichtung nach Anspruch 8, wobei die zweite Pumpe (50) zwischen einem isolierten Modus und einem verknüpften Modus umschaltbar ist, die zweite Schleife (30) in stromabwärtiger Kommunikation mit der zweiten Pumpe (50) steht, während sie sich in dem isolierten Modus befindet, und die erste Schleife (20) in stromabwärtiger Kommunikation mit der zweiten Pumpe (50) steht, während sie sich in dem verknüpften Modus befindet.

10. Vorrichtung nach Anspruch 9, wobei die zweite Pumpe (50) einen ersten Auslass (52) aufweist, der Kühlmittel zu der zweiten Schleife (30) leitet, und die zweite Pumpe (50) einen zweiten Auslass (54) aufweist, der Kühlmittel zu der ersten Schleife (20) leitet.

11. Einrichtung nach einem der Ansprüche 8 bis 10, wobei ein Einlass (41) zu der ersten Pumpe (40) in direkter stromabwärtiger Kommunikation mit dem Komponentenwärmetauscher (22) steht.

12. Vorrichtung nach Anspruch 9, wobei ein Einlass (51) zu der zweiten Pumpe (50) in direkter stromabwärtiger Kommunikation mit dem Kabinenwärmetauscher (34) steht.

13. Vorrichtung nach einem der Ansprüche 8 bis 12, die ferner einen ersten Sensor (26) zum Erfassen der Temperatur des in den Komponentenwärmetauscher (22) eintretenden Kühlmittels und eine Steuerung (68) zum Signalisieren der ersten Pumpe (40), im Kühlermodus zu arbeiten, wenn die Temperatur des in den Komponentenwärmetauscher (22) eintretenden Kühlmittels höher als ein Sollwert ist, und zum Betreiben der ersten Pumpe (40) im Rezirkulationsmodus, wenn die Temperatur des in den Komponentenwärmetauscher (22) eintretenden Kühlmittels niedriger als ein Sollwert ist.

## Revendications

1. Procédé pour refroidir un composant générateur de chaleur (12) d'un véhicule, comprenant :
le pompage d'un fluide de refroidissement depuis une première pompe (40) alors qu'une première pompe est dans un mode de refroidissement dans une première boucle (20) comprenant un échangeur de chaleur de composant (22) et un module de refroidissement (24) ; et
le pompage du fluide de refroidissement depuis ladite première pompe (40) alors que la première pompe est dans un mode de recirculation dans une seconde boucle (30) comprenant un module de chauffage (32) et un échangeur de chaleur de cabine (34) ou de retour jusqu'audit échangeur de chaleur de composant (22) dans ladite première boucle (20), **caractérisé en ce que** ladite première pompe (40) a une première sortie (42) qui dirige le fluide de refroidissement jusqu'audit module de refroidissement (24) dans ladite première boucle (20) et ladite première pompe (40) a une seconde sortie (44) qui dirige le fluide de refroidissement jusqu'à ladite seconde boucle (30) ou de retour jusqu'audit échangeur de chaleur de composant (22) dans ladite première boucle (20).

2. Procédé de la revendication 1, comprenant en outre le pompage du fluide de refroidissement depuis ladite seconde pompe (50) dans ladite seconde boucle (30) alors que la seconde pompe (50) est dans un mode isolé ; et le pompage du fluide de refroidissement depuis ladite seconde pompe (50), depuis ladite seconde boucle (30) jusque dans ladite première boucle (20) alors que la seconde pompe est dans un mode raccordé.

3. Procédé de la revendication 2, dans lequel ladite seconde pompe (50) a une première sortie (52) qui dirige le fluide de refroidissement jusqu'à ladite seconde boucle (30) et ladite seconde pompe (50) a une seconde sortie (54) qui dirige le fluide de refroidissement jusqu'à ladite première boucle (20).

4. Procédé d'une quelconque revendication précédente, dans lequel une entrée de la première pompe (40) reçoit le fluide de refroidissement directement en provenance de l'échangeur de chaleur de composant (22).

5. Procédé de la revendication 2, dans lequel une entrée de la seconde pompe (50) reçoit le fluide de refroidissement directement en provenance de l'échangeur de chaleur de cabine (34).

6. Procédé d'une quelconque revendication précédente, comprenant en outre la détection (26) de la température du fluide de refroidissement entrant dans l'échangeur de chaleur de composant (22) pour déterminer de faire fonctionner la première pompe (40) dans le mode de refroidissement si la température du fluide de refroidissement entrant dans l'échangeur de chaleur de composant (22) est plus haute qu'un point de consigne et de faire fonctionner la première pompe (40) dans le mode de recirculation si la température du fluide de refroidissement entrant dans l'échangeur de chaleur de composant (22) est plus basse qu'un point de consigne.

7. Procédé de la revendication 2 comprenant en outre la détection (39) de la température du fluide de refroidissement entrant dans l'échangeur de chaleur de cabine (34) pour déterminer de faire fonctionner la seconde pompe (50) dans le mode raccordé si la température du fluide de refroidissement entrant dans l'échangeur de chaleur de cabine (34) est au-dessus d'un point de consigne et de faire fonctionner la seconde pompe (50) dans le mode isolé si la température du fluide de refroidissement entrant dans l'échangeur de chaleur de cabine (34) est en dessous d'un point de consigne.

8. Appareil pour refroidir un composant générateur de chaleur (12) d'un véhicule, comprenant :
une première boucle (20) comprenant un échangeur de chaleur de composant (22) et un module de refroidissement (24),
une seconde boucle (30) comprenant un module de chauffage (32) et un échangeur de chaleur de cabine (34) ;
une première pompe (40) commutable entre un mode de refroidissement et un mode de recirculation, la première boucle (20) étant en communication en aval avec ladite première pompe (40) alors qu'elle est dans ledit mode de refroidissement et la seconde boucle (30) ou l'échangeur de chaleur de composant (22) étant en communication en aval avec ladite première pompe (40) alors qu'elle est dans ledit mode de recirculation,
**caractérisé en ce que** ladite première pompe (40) a une première sortie (42) qui dirige un fluide de refroidissement jusqu'à ladite première boucle (20) et ladite première pompe (40) a une seconde sortie (44) qui dirige le fluide de refroidissement jusqu'à ladite seconde boucle (30) ou l'échangeur de chaleur de composant (22).

9. Appareil de la revendication 8, dans lequel ladite seconde pompe (50) est commutable entre un mode isolé et un mode raccordé, ladite seconde boucle (30) est en communication en aval avec ladite seconde pompe (50) alors qu'elle est dans ledit mode isolé, et ladite première boucle (20) est en communication en aval avec ladite seconde pompe (50) alors qu'elle est dans ledit mode raccordé.

10. Appareil de la revendication 9, dans lequel ladite seconde pompe (50) a une première sortie (52) qui dirige le fluide de refroidissement jusqu'à ladite seconde boucle (30) et ladite seconde pompe (50) a une seconde sortie (54) qui dirige le fluide de refroidissement jusqu'à ladite première boucle (20).

11. Appareil de l'une quelconque des revendications 8 à 10, dans lequel une entrée (41) de la première pompe (40) est en communication en aval directe avec l'échangeur de chaleur de composant (22).

12. Appareil de la revendication 9, dans lequel une entrée (51) de la seconde pompe (50) est en communication en aval directe avec l'échangeur de chaleur de cabine (34).

13. Appareil de l'une quelconque des revendications 8 à 12, comprenant en outre un premier capteur (26) destiné à détecter la température du fluide de refroidissement entrant dans l'échangeur de chaleur de composant (22) et une unité de commande (68) destinée à signaler à la première pompe (40) de fonctionner dans le mode de refroidissement si la température du fluide de refroidissement entrant dans l'échangeur de chaleur de composant (22) est plus haute qu'un point de consigne et pour faire fonctionner la première pompe (40) dans le mode de recirculation si la température du fluide de refroidissement entrant dans l'échangeur de chaleur de composant (22) est plus basse qu'un point de consigne.
